# EUROPÄISCHE PATENTANMELDUNG

(11) **EP 1 333 080 A2**
(43) Veröffentlichungstag der Anmeldung: **06.08.2003**
(21) Anmeldenummer: 03001003.7
(22) Anmeldetag: 17.01.2003
(51) Int. Cl.: C09K 3/14, H01L 21/321, H01L 21/306, C09G 1/02

(54) **Wässerige Dispersion enthaltend mit Ceroxid umhülltes Siliciumdioxidpulver, Verfahren zu deren Herstellung und ihre Verwendung**

(30) Priorität: 05.02.2002 DE 10204471
(71) Anmelder: Degussa AG, 40474 Düsseldorf (DE)
(72) Erfinder: Schumacher, Kai, Dr., 65719 Hofheim (DE); Meyer, Jürgen, Dr., 63811 Stockstadt/Main (DE); Mangold, Helmut, Dr., 63517 Rodenbach (DE); Lortz, Wolfgang, Dr., 63607 Wächtersbach (DE); Batz-Sohn, Christoph, Dr., 63454 Hanau-Mittelbuchen (DE)

(57) **Zusammenfassung**

Wässerige Dispersion, die ein Pulver enthält, welches aus einem Kern aus dotiertem, pyrogen hergestelltem Siliciumdioxid mit einer niedrigen Struktur durch Vermischen, vorzugsweise Besprühen, mit einer Cersalzlösung oder -Suspension unter Bildung einer Ceroxidhülle, erhalten wird, wobei das Pulver in der Dispersion eine mittlere Sekundärpartikelgrösse von 0,2 µm nicht überschreitet. Die Dispersion findet Verwendung beim chemisch-mechanischen Polieren.

## Beschreibung

Gegenstand der Erfindung ist eine wässerige Dispersion, welche ein mit Ceroxid umhülltes Siliciumdioxidpulver enthält, deren Herstellung und ihre Verwendung zum chemisch-mechanischen Polieren.

Ceroxid-Dispersionen, erhalten durch Calcinierung einer Cerverbindung und anschließendes Vermahlen des Oxides, werden seit langem zum Polieren von Glas eingesetzt. Die Dispersionen weisen Partikelgrößen von mehr als 1000 nm und einen hohen Anteil an Verunreinigungen auf. Sie sind geeignet für ein grobes Polieren von Oberflächen, nicht jedoch für das Polieren von empfindlichen optischen Oberflächen, Halbleitersubstraten oder integrierten Schaltkreisen (Chemisch-Mechanisches Polieren, CMP).

Kleinere Ceroxidpartikel werden bei der sogenannten Hydrothermalsynthese erhalten. Dabei wird ein Cer(III)-Salz unter Einfluß von Temperatur und Druck oxidativ in Ceroxid überführt, das in Form feiner Partikel auskristallisiert. Die Partikelgrößen des nach diesem Prozeß erhaltenen Ceroxides liegen bei 80-100 nm (EP-A-947 469), 7-50 nm (US 5,389,352) beziehungsweise kleiner als 30 nm und größer als 60 nm (US 5,772,780). Nachteilig bei dieser Methode ist, daß von sehr verdünnten Cer(III)-Lösungen ausgegangen werden muß.

In US 5,891,205 sind Gemische aus nach oben genanntem Verfahren hergestellten Ceroxid und Siliziumdioxid beschrieben. Dabei muß das Ceroxid in einem ersten Schritt mittels einer Mühle deagglomeriert werden. In einem zweiten Schritt wird die Ceroxid-Dispersion mit einer Siliziumdioxid-Dispersion auf Basis Kieselsol gemischt und kann zum Planarisieren von Siliziumscheiben verwendet werden.

Nachteilig ist hier der hohe Aufwand und die Kosten, die zur Herstellung dieser feinteiligen Dispersion nötig sind. Die Deagglomeration des Ceroxides mittels einer Mühle birgt die Gefahr der Einschleusung von Verunreinigungen in die Dispersion. Ferner ist bekannt, daß Siliziumdioxid-Dispersionen auf Basis Kieselsol einen höheren Anteil an Verunreinigungen aufweisen als solche auf Basis pyrogen hergestellten Siliziumdioxides.

US 5,382,272 beschreibt die Aktivierung von Siliziumdioxidteilchen durch Adsorption von wenigen Gewichtsprozenten, bevorzugt zwei Gewichtsprozent, einer Cer- oder Zirkonoxiddispersion. Das Besondere an diesem Verfahren ist, daß sich der aktivierende Effekt einfach durch Vermahlen einer Siliziumdioxid-Dispersion mit einer kommerziell erhältlichen Cer- beziehungsweise Zirkonoxid-Dispersion einstellen soll. Die so erhaltene gemischte Dispersion soll sich beim Polieren von Halbleitersubstraten mit einer hohen Abtragsrate wie eine reine Ceroxid-Dispersion verhalten, jedoch ohne Kratzer auf der zu polierenden Oberfläche zu hinterlassen. Im Vergleich zum restlichen Stand der Technik sind die Kosten minimal und die Ausführung einfach. Besonders nachteilig bei dieser Methode ist, wie auch ausführlich in WO 00/17 282 A1 beschrieben, die Herstellung einer Dispersion mit engem Partikelgrößenbereich und das Erzielen reproduzierbarer Polierergebnisse.

US 5,697,992 beschreibt die Herstellung eines Pulvers von Abrasivpartikeln und daraus hergestellten, wässerigen Dispersionen. Die Abrasivpartikel bestehen aus Siliciumdioxid oder Aluminiumoxid und einer Hülle aus Ceroxid und haben eine mittlere Partikelgröße von 2 µm oder weniger. Dabei ist unklar, ob sich die angegebene Partikelgröße auf das Pulver oder die Dispersion bezieht.

Für mit Ceroxid umhüllte Siliciumdioxidpartikel wird in einem Beispiel eine Partikelgröße von 0,6 um angegeben. Die Metalloxide stammen entweder aus einem Sol-Gel- oder aus einem pyrogenen Prozess. Nachteilig bei diesem Verfahren ist das Verbacken der Metalloxidpartikel, insbesonders der pyrogener Herkunft, beim Umhüllen mit einer Cerverbindung. Dies führt zu harten, schwer dispergierbaren Aggregaten. In der Dispersion kann dies zu einer sehr breiten Partikelgrößenverteilung führen und mitunter zur Ablösung von Teilen der Hülle in Form von Ceroxid beim Dispergieren. Eine solche Dispersion ist nicht einheitlich und bei der fortschreitenden Miniaturisierung in der Halbleiterindustrie nur eingeschränkt zum reproduzierbaren Polieren von oxidischen Oberflächen geeignet.

Wie der Stand der Technik zeigt, besteht reges Interesse die außergewöhnlich hohe Aktivität von Ceroxid gegenüber Siliziumdioxid und anderen dielektrischen Oxiden hauptsächlich im Bereich chemisch-mechanisches Polieren (CMP)zu nutzen.

Die technische Aufgabe der Erfindung ist es, eine wässerige, Ceroxid enthaltende Dispersion bereitzustellen, die sich einfach herstellen läßt, die nur einen geringen Anteil an Verunreinigungen aufweist, und bei der sich die Partikelgröße reproduzierbar einstellen läßt.

Die Aufgabe wird durch eine wässerige Dispersion gelöst, welche ein Pulver enthält, welches aus einem Kern aus dotiertem, pyrogen hergestelltem Siliciumdioxid mit einer niedrigen Struktur durch Vermischen, vorzugsweise Besprühen, mit einer Cersalzlösung oder -Suspension unter Bildung einer Ceroxidhülle, erhalten wird, wobei das Pulver in der Dispersion eine mittlere Sekundärpartikelgrösse von 0,2 µm nicht überschreitet.

Unter wässeriger Dispersion ist eine Dispersion zu verstehen deren Hauptbestandteil der flüssigen Phase Wasser ist.

Unter einem Kern bestehend aus einem dotierten, pyrogen hergestellten Siliciumdioxid ist ein Kern zu verstehen, bei dem die Dotierung über ein Aerosol aus einer Salzlösung oder -suspension, welche die Dotierkomponente enthält, eingebracht wird. Die Herstellung solcher Kerne ist zum Beispiel in DE-A-196 50 500 beschrieben.

Unter niedriger Struktur ist zu verstehen, dass der Kern aus vielen einzelnen sphärischen Primärpartikeln besteht, die nur wenig miteinander verwachsen sind. Ein Maß für die niedrige Struktur ist die DBP-Absorption (Dibutylphtalatabsorption). Diese ist kleiner als 100 g DBP /100 g Pulver, wobei sich der Begriff Pulver hier auf den dotierten Kern bezieht. Es ist ebenfalls möglich, dass kein Endpunkt in der DBP-Absorption zu erkennen ist. Bei einem pyrogen hergestellten, nicht dotierten Siliciumdioxid mit gleicher BET-Oberfläche, bei dem die Primärpartikel stärker verwachsen sind, liegt die DBP-Absorption üblicherweise bei mehr als 150 g DBP/100 g Pulver. Zum Beispiel weist das kommerziell erhältliche, pyrogen hergestellte Siliciumdioxid OX 50, Firma Degussa AG, eine DBP-Absorption von 160 g DBP /100 g Pulver auf.

Bei der DBP-Absorption wird die Kraftaufnahme, beziehungsweise das Drehmoment (in Nm), der rotierenden Schaufeln des DBP-Meßgerätes bei Zugabe definierter Mengen von DBP, vergleichbar einer Titration, gemessen. Dabei ergibt sich für pyrogene Metalloxide (zum Beispiel Titandioxid oder Siliciumdioxid) ein scharf ausgeprägtes Maximum mit einem anschließenden Abfall bei einer bestimmten Zugabe von DBP. Bei Partikeln mit sehr geringem Verwachsungsgrad ist es auch möglich, dass das Meßgerät keinen Endpunkt ermitteln kann.

Die niedrige Struktur des Kernes kann auch TEM-Aufnahmen entnommen werden.

Als Cersalzlösung- oder suspension werden verwendet: Cerchlorid, Cernitrat, Ceracetat, Cercarbonat, Ceroxalat, Cersulfat, Ammoniumcersulfat, Ammoniumcernitrat.

Zum Aufbringen der Hülle wird die wässerige und/oder alkoholische Aufschlämmung des Kernes mit einer Cersalzlösung oder -suspension vermischt, bevorzugt besprüht. Das Reaktionsgemisch wird getrocknet und gegebenenfalls calciniert. Unter den Reaktionsbedingungen wird die Cersalzlösung oder -suspension in Ceroxid überführt. Die Ceroxidhülle kann teilweise oder vollständig ausgebildet sein.

Der Gehalt an Dotierungskomponente im Kern liegt zwischen 10 ppm und 10 Gew.-%. Der Gehalt an Ceroxid im umhüllten Kern liegt zwischen 10 ppm und 65 Gew.-% liegt.

Die BET-Oberfläche des Pulvers liegt zwischen 5 und 600 m²/g.

Die mittlere Sekundärpartikelgröße in der erfindungsgemäßen Dispersion ist kleiner als 0,2 µm. Sie kann zum Beispiel durch dynamische Lichtstreuung bestimmt werden.

Bevorzugt können Kerne eingesetzt werden, deren Dotierungskomponente ein Alkalioxid oder Aluminiumoxid ist.

Der Feststoffgehalt der erfindungsgemäßen Dispersion richtet sich in erster Linie nach der beabsichtigten Verwendung. Um Transportkosten einzusparen wird man eine Dispersion mit möglichst hohem Feststoffgehalt anstreben, während bei bestimmten Anwendungen, wie zum Beispiel beim Polieren Dispersionen mit niedrigen Feststoffgehalten . eingesetzt werden. Bevorzugt gemäß der Erfindung ist ein Feststoffgehalt von 0,1 bis 70 Gew.-%., besonders bevorzugt der Bereich zwischen 1 und 30 Gew.-%.

Der pH-Wert der erfindungsgemäßen Dispersion kann zwischen 3 und 11 liegen.

Die erfindungsgemäße Dispersion kann ferner Additive aus der Gruppe umfassend pH-Wert regulierende Substanzen wie Säuren, Basen und/oder Puffersysteme, Oxidationsmittel, Oxidationsaktivatoren, Korrosionsinhibitoren, Abrasive und/oder oberflächenaktive Stoffe enthalten.

Eine Erhöhung des pH-Wertes kann bevorzugt durch Addition von Alkalihydroxiden oder Aminen erfolgen. Besonders bevorzugt können Ammoniumhydroxid, Kaliumhydroxid und Tetramethylammoniumhydroxid eingesetzt werden.

Durch-Zugabe von Säuren kann der pH-Wert in den sauren Bereich bis pH 3 verschoben werden. Bevorzugt werden hierzu Carbonsäuren der allgemeinen Formel CₙH₂ₙ₊₁CO₂H, mit n=0-6 oder n=8,10,12,14,16, oder Dicarbonsäuren der allgemeinen Formel HO₂C(CH₂)ₙCO₂H, mit n=0-4, oder Hydroxycarbonsäuren der allgemeinen Formel R₁R₂C(OH)CO₂H, mit R₁=H, R₂=CH₃, CH₂CO₂H, CH(OH)CO₂H oder Glykolsäure, Brenztraubensäure, Salicylsäure oder Mischungen der aufgeführten Säuren verwendet. Besonders bevorzugt können hierzu Essigsäure, Zitronensäure und Salicylsäure eingesetzt werden.

Ein weiterer Gegenstand der Erfindung ist ein Verfahren zur Herstellung der erfindungsgemäßen Dispersion, welches dadurch gekennzeichnet ist, dass das Pulver in einem wässerigen Medium, gegebenenfalls unter Zusatz von Additiven, zunächst vordispergiert und die Vordispersion anschließend dispergiert.

Unter Vordispersion ist eine Dispersion mit einer mittleren Partikelgröße von maximal 1 mm zu verstehen. Zur Vordispergierung eignen sich zum Beispiel Dissolver oder Zahnradscheibe.

Zur Dispergierung eignen sich Rotor-Stator-Maschinen, wie Ultra Turrax (Firma IKA), oder solche der Firma Ystral, ferner Kugelmühlen, Rührwerkskugelmühlen.

Höhere Energieeinträge sind mit einem Planetenkneter/-mixer möglich. Die Wirksamkeit dieses Systems ist jedoch mit einer ausreichend hohen Viskosität der bearbeiteten Mischung verbunden, um die benötigten hohen Scherenergien zum Zerteilen der Teilchen einzubringen.

Mit Hochdruckhomogenisatoren können besonders feinteilige Dispersionen hergestellt werden. Bei diesen Vorrichtungen werden zwei unter hohem Druck stehende vordispergierte Suspensionsströme über eine Düse entspannt. Beide Dispersionsstrahlen treffen exakt aufeinander und die Teilchen mahlen sich selbst. Bei einer anderen Ausführungsform wird die Vordispersion ebenfalls unter hohen Druck gesetzt, jedoch erfolgt die Kollision der Teilchen gegen gepanzerte Wandbereiche. Die Operation kann beliebig oft wiederholt werden um kleinere Teilchengrößen zu erhalten.

Zur Herstellung der erfindungsgemäßen Dispersion kann bevorzugt ein Hochdruckhomogenisator eingesetzt werden.

Ein weiterer Gegenstand der Erfindung ist die Verwendung der erfindungsgemäßen Dispersion zum chemisch-mechanischen Polieren von Halbleitersubstraten oder von auf ihnen aufgebrachten Schichten, insbesondere das Polieren von oxidischen und metallischen Schichten, und im Shallow-Trench-Isolation Prozess (STI-Prozess). Bei diesem Prozess werden nach dem Aufbringen einer Siliciumnitridschicht Isolationsstrukturen in die Siliciumschicht eines Wafers geätzt, die entstandenen Gräben anschließend mit Siliciumdioxid gefüllt und überschüssiges Siliciumdioxid durch chemisch-mechanisches Polieren entfernt.

Es wurde also gefunden, dass das Pulver, das aus dotierten, pyrogen hergestellten Siliciumdioxidpartikeln mit niedriger Struktur und einer Cersalzlösung oder -suspension erhalten wird, sich reproduzierbar zu Sekundärteilchengrößen von maximal 0,2 µm in einem wässerigen Medium dispergieren läßt, ohne dass es zu Ablösungen von Ceroxid und zur Bildung von groben Partikeln kommt. Dieses Ergebnis ist überraschend, da eine zum Beispiel nach US 5,697,992 erhaltene Dispersion, die als Kern nicht dotiertes Siliciumdioxid enthält, sich nicht reproduzierbar dispergieren läßt und es zu Ablösungen von Ceroxid kommt.

### Beispiele

### Analysenverfahren

Die durchschnittliche Sekundärteilchengröße wird mit dem Zetasizer 3000 Hsa der Firma Malvern bestimmt.

Die BET-Oberfläche wird bestimmt nach DIN 66131. Der Trocknungsverlust TV wird bestimmt in Anlehnung an DIN/ISO 787/II, ASTM D 280, JIS K 5101/21 über einen Zeitraum von 2 Stunden bei 105°C. Der Glühverlust GV wird bestimmt in Anlehnung an DIN 55921, ASTM D 1208, JIS K 5101/23, bezogen auf die 2h bei 105 °C getrocknete Substanz über einen Zeitraum von 2 Stunden bei 1000 °C.

Die Viskosität der Dispersionen wird mit einem Rotations-Rheometer der Firma Physica Model MCR 300 und dem Meßbecher CC 27 ermittelt. Der Viskositätswert wird bei einer Schergeschwindigkeit von 100 1/sec. ermittelt. Diese Schergeschwindigkeit liegt in einem Bereich, in dem die Viskosität praktisch unabhängig von der Scherbeanspruchung ist.

Die Beurteilung einer Bodensatzbildung erfolgt durch visuelle Beurteilung in einer 1000 ml Weithals-Polyethylen-Flasche nach einer Standzeit von einer Woche. Durch vorsichtiges Kippen der Flasche kann leicht ein gegebenenfalls vorhandener Bodensatz erkannt werden.

### Pulver

### Pulver 1 (P1) : Mit Ceroxid umhülltes und mit Aluminiumoxid dotiertes Siliciumdioxidpulver

15 kg mit 0,25 Gew.-% Al₂O₃ dotiertes Siliciumdioxidpulver (DBP-Zahl: 80g/100g), erhalten nach DE-A-198 47 161 werden mit einer Lösung aus 5 kg Cernitrat [(Ce(NO₃)₃ x 6H₂O)] in 3 1 Wasser besprüht. Das Wasser wird bei 90°C eintrocknen lassen. Anschließend erfolgt eine Temperaturbehandlung bei 500°C für 3 h.

### Pulver 2 (P2): Mit Ceroxid umhülltes und mit Kaliumoxid dotiertes Siliciumdioxid

15 kg mit 0,2 Gew.-% Kaliumoxid dotiertes Siliciumdioxid (DBP-Zahl nicht bestimmbar), erhalten nach DE-A-196 50 500 werden mit einer Lösung aus 5 kg Cernitrat [(Ce(NO₃)₃ x 6H₂O)] in 3 1 Wasser besprüht. Das Wasser wird bei 90°C eintrocknen lassen. Anschließend erfolgt eine Temperaturbehandlung bei 500°C für 3 h.

### Pulver 3 (P3): Aerosil 90

Kommerziell erhältliches Aerosil® 90, Fa. Degussa.

Die analytischen Daten der Pulver P1 bis P3 zeigt Tabelle 1.

**Tabelle 1:**

| **Analytische Daten der Pulver P1 bis P3** | | | | | |
|---|---|---|---|---|---|
| | **SiO**_{**2**} Gew.-% | **CeO**_{**2**} Gew.-% | **BET** m²/g | **TV** Gew.-% | **GV** Gew.-% |
| **P1** | 91,50 | 8,25 | 61 | 1,9 | 0,8 |
| **P2** | 92,70 | 9,10 | 121 | 2,4 | 0,3 |
| **P3** | >99,9 | - | 90 | 0,9 | 0,8 |

### Dispersionen

**Methode A:** In einem 60 1 Edelstahl-Ansatzbehälter werden 18,0 kg VE-Wasser und 80 g 30 prozentige KOH-Lösung vorgelegt. Mit Hilfe eines Dispergier- und Saugmischers der Firma Ystral (bei 4500 UpM) werden 6,25 kg eines der Pulver P1 bis P3 eingesaugt und grob vordispergiert. Nach dem Pulvereintrag wird die Dispergierung mit einem Rotor/Stator Durchlaufhomogenisator Typ Z 66 der Firma Ystral mit vier Bearbeitungskränzen, einer Statorschlitzbreite von 1 mm und einer Drehzahl von 11 500 UpM vervollständigt. Während dieser 15 minütigen Dispergierung mit 11 500 UpM wird der pH-Wert durch Zugabe von weiterer KOH-Lösung auf einen pH-Wert von 10,5 eingestellt und gehalten. Hierbei wurden weitere 150 g KOH-Lösung verwendet und durch Zugabe von 0,5 kg Wasser eine Abrasivkörper-Konzentration von 25 Gew.-% eingestellt. Nach Entnahme von 12,5 kg Dispersion für Methode B werden 12,5 kg VE-Wasser aus dem Ansatzbehälter hinzugegeben und die nun 12,5 prozentige Dispersion 5 Minuten mit der Durchlaufhomogenisator bei einer Drehzahl von 11 500 UpM homogenisiert.

Man erhält die Dispersionen D1-A, D2-A, D3-A.

**Methode B:** Ca. die Hälfte der Dispersion nach Methode A wird mit einem Hochdruckhomogenisator, Ultimaizer System der Firma Sugino Machine Ltd., Modell HJP-25050, bei einem Druck von 250 MPa und einem Diamantdüsendurchmesser von 0,3 mm und zwei Mahl-Durchgängen vermahlen.

Nach der Vermahlung wurden 12,5 kg VE-Wasser und 12,5 kg der vermahlenen Dispersion in einen 60 1 Edelstahl-Ansatzbehälter gegeben und die nun 12,5 prozentige Dispersion 5 Minuten mit dem Durchlaufhomogenisator Typ Z 66 der Firma Ystral bei einer Drehzahl von 11 500 UpM homogenisiert.

Man erhält die Dispersionen D1-B, D2-B, D3-B.

Die analytischen Daten der Dispersion sind in Tabelle 2 dargestellt.

Stabile Dispersionen, die keinen Bodensatz bilden, können nur nach der Dispergiermethode B erhalten werden. Die mittleren Teilchendurchmesser der nach Methode B erhaltenen Dispersionen sind deutlich kleiner, als die nach Methode A erhaltenen. Die Dispersionen D1-B und D2-B, die mit Ceroxid umhüllte Siliciumdioxidpartikel enthalten, zeigen mittlere Partikeldurchmesser, anzahl- und volumenbezogen, von kleiner als 200 nm.

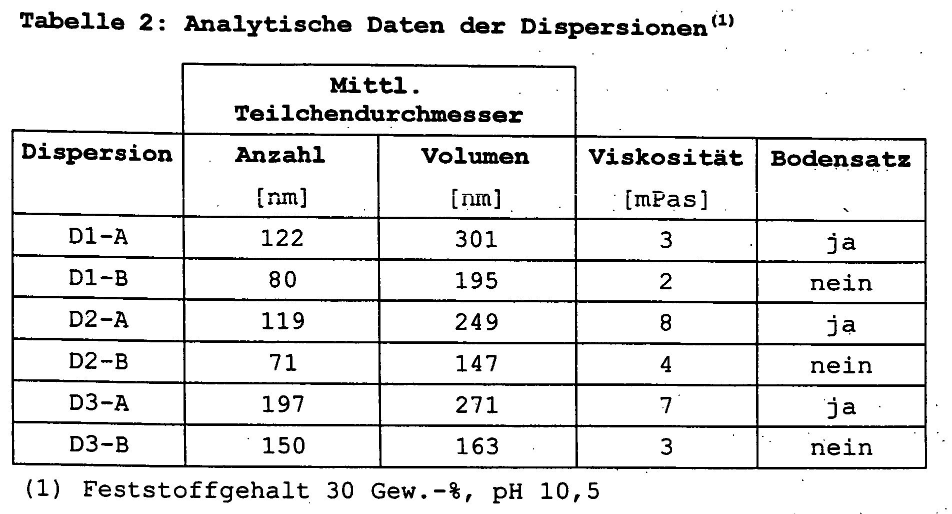

### Polierprozeß

Ausrüstung: Presi Polisher Type 460 M, ausgerüstet mit einem 550 mm Poliertisch mit Poliertuch Rodel IC 1400 perforiert.

Wafer: 4'' Siliciumscheiben beschichtet mit 500 nm SiO₂ (thermisch erzeugt), 4'' Siliciumscheiben beschichtet mit 500 nm Si₃N₄ (LPCVD).

Die Polierparameter sind in Tabelle 3 gegeben.

Die Auswertung der Abtragsleistung (Removal Rate, RR) erfolgt durch Messungen der Schichtdicke mit dem Gerät Prometrix FDT 650 (KLA-Tencor Corporation) und durch Auswiegen der Wafer mit einer Satorius BP 210D Waage. Für die mittlere RR wurden jeweils 10 Wafer poliert und ausgewertet.

Grobe Kratzer und Defekte wurden mit einem Gerät der Firma Tencor Modell Surfscan 5000 ausgewertet.

**Tabelle 3:**

| **Polierparameter** | |
|---|---|
| Polierdauer/Polierdruck | 15 s/0.2 bar, 60 s/0.8 bar, |
| | 15 s/0.2 bar Spülung |
| Rotationsgeschwindigkeit | 60 rpm |
| Dosiergeschwindigkeit Dispersion | 100 ml/min |
| Temperatur | ca. 25°C |
| Konditionierung | vor jedem Polierversuch mit einer Diamant-Schleifkopfscheibe bei 1 bar, Dauer 10 s |
| Post CMP Cleaning | Ultraschallreinigung (Fa. Techsonic) und einem Bürstenreiniger SVG 8620 single side cleaner/dryer. |

Die Werte für die Abtragsleistungen und die Selektivitäten der Dispersionen sind in Tabelle 4 zusammengefasst.

Dabei zeigt sich, dass bei Verwendung der erfindungsgemäßen Dispersionen D1-B und D2-B bei hohen Abtragsraten und guten Selektivitäten keine Kratzer beim Polieren von Siliciumdioxidoberflächen zu detektieren sind. Die Dispersionen D1-A und D2-A zeigen zwar ebenfalls hohe Abtragsraten und gute Selektivitäten, jedoch können Kratzer und Defekte detektiert werden, die die Verwendung als Poliersuspension einschränken. Insgesamt zeigen alle untersuchten, mit Ceroxid umhüllten, dotierten Siliciumdioxiddispersionen bessere Werte für Abtragsrate, Selektivität und Defektanzahl als eine Dispersion, welche auf reinem Siliciumdioxid basiert (D3-A, D3-B).

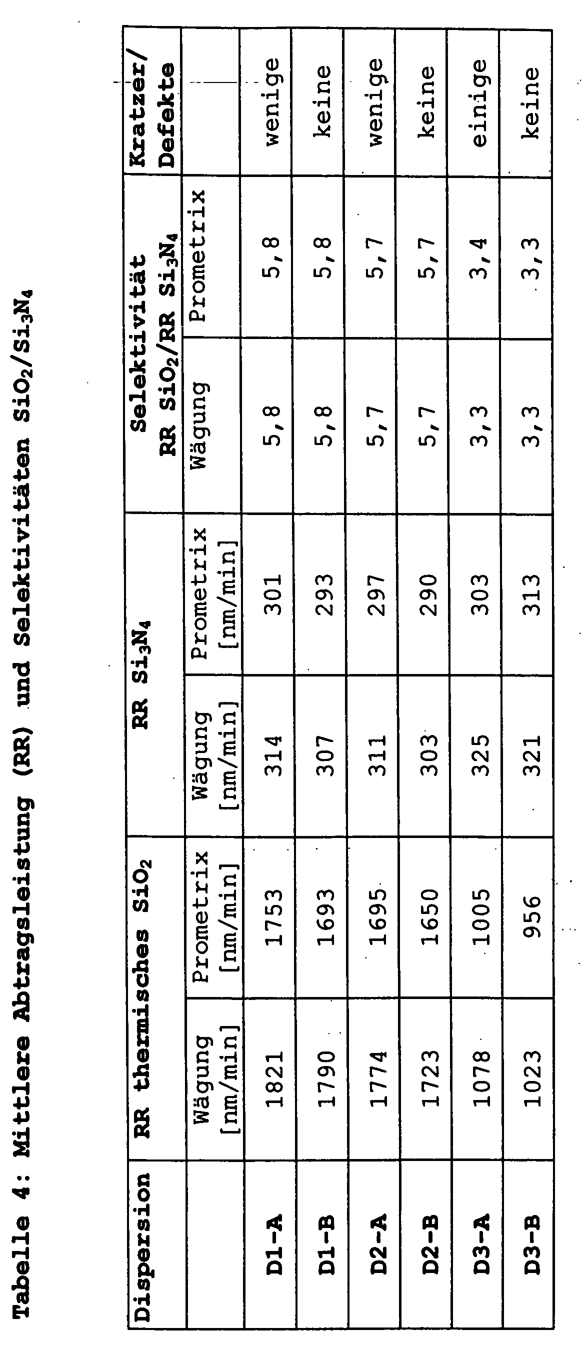

## Patentansprüche

1. Wässerige Dispersion, **dadurch gekennzeichnet, daß** diese ein Pulver enthält, welches aus einem Kern aus dotiertem, pyrogen hergestelltem Siliciumdioxid mit einer niedrigen Struktur durch Vermischen, vorzugsweise Besprühen, mit einer Cersalzlösung oder -Suspension unter Bildung einer Ceroxidhülle, erhalten wird, wobei das Pulver in der Dispersion eine mittlere Sekundärpartikelgrösse von 0,2 µm nicht überschreitet.

2. Wässerige Dispersion nach Anspruch 1, **dadurch gekennzeichnet, dass** die Dotierung Alkalioxid oder Aluminiumoxid ist.

3. Wässerige Dispersion nach den Ansprüchen 1 oder 2, **dadurch gekennzeichnet, daß** der Feststoffgehalt in der Dispersion zwischen 0,1 und 70 Gew.-% liegt.

4. Wässerige Dispersion nach den Ansprüchen 1 bis 3, **dadurch gekennzeichnet, daß** der pH-Wert der Dispersion zwischen 3 und 11 liegt.

5. Wässerige Dispersion nach den Ansprüchen 1 bis 4, **dadurch gekennzeichnet, dass** sie Additive aus der Gruppe umfassend pH-Wert regulierende Substanzen wie Säuren, Basen und/oder Puffersysteme, Oxidationsmittel, Oxidationsaktivatoren, Korrosionsinhibitoren, Abrasive und/oder oberflächenaktive Stoffe enthält.

6. Verfahren zur Herstellung einer wässerigen Dispersion gemäß den Ansprüchen 1 bis 5, **dadurch gekennzeichnet, dass** man das Pulver in einem wässrigen Medium, gegebenenfalls unter Zusatz von Additiven, zunächst vordispergiert und die Vordispersion anschließend dispergiert.

7. Verwendung der wässerigen Dispersion nach den Ansprüchen 1 bis 5 zum chemisch-mechanischen Polieren von Halbleitersubstraten oder von auf ihnen aufgebrachten Schichten und im Shallow-Trench-Isolation Prozess.
